# EUROPEAN PATENT APPLICATION

(11) **EP 4 686 361 A2**
(43) Date of publication of application: **28.01.2026**
(21) Application number: 25177920.3
(22) Date of filing: 21.05.2025
(51) Int. Cl.: H10K 59/38, H10K 59/80

(54) **DISPLAY APPARATUS HAVING A LIGHT-EMITTING DEVICE**

(30) Priority: 26.07.2024 KR 20240099361
(71) Applicant: LG Display Co., Ltd., Seoul 150-721 (KR)
(72) Inventor: BAIK, Seung Min, Paju-si, Gyeonggi-do 10845 (KR); KANG, Yeon Suk, Paju-si, Gyeonggi-do 10845 (KR)
(74) Representative: Viering, Jentschura & Partner mbB Patent- und Rechtsanwälte

(57) **Abstract**

A display apparatus including a light-emitting device (300) is provided. The light-emitting device (300) can be disposed on an emission area (R-EA, B-EA, G-EA) of a device substrate (100). A lower lens (500), a barrier pattern (600), and an upper lens (700) can be disposed on the light-emitting device (300). The lower lens (500) and the upper lens (700) overlapping with the emission area (R-EA, B-EA, G-EA) can have a curved surface (500s, 700s) of convex shape toward each other. At least two of the lower lens (500), the barrier pattern (600), and the upper lens (700) can include a color material. Thus, in the display apparatus, the reduction in viewing angle can be minimized, and the color mixing can be prevented or reduced.

## Description

### CROSS-REFERENCE TO RELATED APPLICATION

This application claims the benefit of Korean Patent Application No. 10-2024-0099361, filed on July 26, 2024.

### BACKGROUND

### Field

The present disclosure relates to a display apparatus in which a light-emitting device is disposed on an emission area of a device substrate.

### Discussion of the Related Art

Generally, a display apparatus provides an image to a user. For example, the display apparatus can include light-emitting devices disposed on emission areas of a device substrate. The light-emitting device of each emission area can emit light displaying a specific color. For example, the light-emitting device of each emission area can include an emission material layer disposed between a first electrode and a second electrode.

The image provided to the user can include various colors. For example, a color filter and a pixel lens can be disposed on a path of the light emitted from the light-emitting device of each emission area. Thus, in the display apparatus, the color mixing can be prevented or reduced. However, in the display apparatus, a viewing angle can be reduced by the pixel lens on each emission area. Therefore, in the display apparatus, the quality of the image can vary greatly depending on the location of the user.

### SUMMARY

Accordingly, the present disclosure is directed to a display apparatus that substantially obviates one or more problems due to limitations and disadvantages of the related art.

An object of the present disclosure is to provide a display apparatus capable of reducing a difference in the quality of the image according to the location of the user.

Another object of the present disclosure is to provide a display apparatus in which the reduction in the viewing angle of the light emitted from each emission area can be minimized and the color mixing can be prevented or reduced.

Additional advantages, objects, and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

To achieve these objects and other advantages and in accordance with the purpose of the present disclosure, as embodied and broadly described herein, there is provided a display apparatus according to claim 1 and a display apparatus according to claim 8. Further embodiments are described in the dependent claims. In an aspect of the present disclosure, there is provided a display apparatus comprising a device substrate. A light-emitting device is disposed on an emission area of the device substrate. A lower lens and a barrier pattern are disposed on the light-emitting device. The lower lens overlaps the emission area. The barrier pattern surrounds an edge of the lower lens. An upper lens is disposed on the lower lens and the barrier pattern. The upper lens can include a color material. The upper lens overlaps the emission area. A surface of the lower lens toward the upper lens and a surface of the upper lens toward the lower lens have a cross-section of convex shape. One of the lower lens and the barrier pattern includes a color material displaying a same color as the upper lens.

The color material can include a dye or a pigment displaying one of a red color, a green color and a blue color.

A refractive index of the barrier pattern can be smaller than a refractive index of the lower lens.

A thickness of the barrier pattern can be larger than the maximum thickness of the lower lens. A surface of the lower lens toward the upper lens can be in contact with the barrier pattern.

The display apparatus can further include a lens planarization layer. A surface of the upper lens toward the lower lens can be in contact with the lens planarization layer. A refractive index of the lens planarization layer can be smaller than a refractive index of the upper lens.

A surface of the lens planarization layer toward the device substrate can be in contact with a surface of the barrier pattern opposite to the device substrate.

Each of the lower lens and the upper lens can have a larger size than the emission area.

A size of the upper lens can be different from a size of the lower lens.

The lens planarization layer can include a first planarization layer provided on the barrier pattern and a second planarization layer provided between the first planarization layer and the upper lens. A refractive index of the first planarization layer can be between a refractive index of the barrier pattern and a refractive index of the second planarization layer, and the second planarization layer can have a smaller refractive index than the upper lens.

In another aspect, there is provided a display apparatus comprising a device substrate. A light-emitting device is disposed on an emission area of the device substrate. A lower lens is disposed on the light-emitting device. The lower lens has a first curved surface on a side opposite to the device substrate. At least a portion of the first curved surface is surrounded by a barrier pattern. The barrier pattern includes a first color material. An upper lens is disposed on the lower lens and the barrier pattern. The upper lens has a second curved surface toward the first curved surface. The first curved surface and the second curved surface overlapping with the emission area have a convex shape toward each other. At least one of the lower lens and the upper lens includes a second color material displaying a different color from the first color material.

The barrier pattern can be disposed outside the emission area.

The display apparatus can further include a lens planarization layer. The lens planarization layer can be disposed between the lower lens and the upper lens. The lens planarization layer can have a refractive index smaller than a refractive index of the lower lens.

The first curved surface of the lower lens can include a first region and a second region. The first region can be in contact with the barrier pattern. The second region can be in contact with the lens planarization layer. The second region can be disposed closer to the center of the emission area than the first region.

The first color material can include a dye or a pigment displaying a black color.

An upper surface of the upper lens opposite to the device substrate can be parallel to a lower surface of the lower lens toward the device substrate.

The lens planarization layer can include a first planarization layer and a second planarization layer. The second planarization layer can be disposed on the first planarization layer. The first planarization layer can include a third color material displaying a same color as the second color material.

The second curved surface of the upper lens can have a different curvature from the first curved surface of the lower lens.

The display apparatus can include a plurality of sub-pixels, each of which includes the lower lens, the upper lens and the barrier pattern. The barrier pattern of each sub-pixel can include a different color material from the barrier pattern of an adjacent sub-pixel.

The barrier pattern of at least one sub-pixel of the plurality of sub-pixels can include a color material displaying a different color from the upper lens of the at least one sub-pixel and the upper lens of the adjacent sub-pixel, and/or the barrier pattern of at least one sub-pixel of the plurality of sub-pixels can include a color material displaying a different color from the lower lens of the at least one sub-pixel and the lower lens of the adjacent sub-pixel.

It is to be understood that both the foregoing general description and the following detailed description of the present disclosure are by way of example and are intended to provide further explanation of the disclosures as claimed.

### BRIEF DESCRIPTION OF THE DRAWINGS

The accompanying drawings, which are included to provide a further understanding of the present disclosure and are incorporated in and constitute a part of this application, illustrate example embodiment(s) of the present disclosure and together with the description serve to explain various principles of the present disclosure. In the drawings:
FIG. 1 is a view schematically showing a display apparatus according to an example embodiment of the present disclosure;
FIG. 2 is a view showing a circuit of a sub-pixel in the display panel of the display apparatus according to an example embodiment of the present disclosure;
FIG. 3 is a view showing a cross-section of a pixel area in the display panel of the display apparatus according to an example embodiment of the present disclosure;
FIG. 4 is an enlarged view of K1 region in FIG. 3;
FIGs. 5 to 15 are views showing the display apparatus according to additional example embodiments of the present disclosure.

### DETAILED DESCRIPTION

Hereinafter, details related to the above objects, technical configurations, and operational effects of various embodiments of the present disclosure will be clearly understood by the following detailed description with reference to the drawings, which illustrate some example embodiments of the present disclosure. Here, the embodiments of the present disclosure are provided to allow the technical sprit of the present disclosure to be satisfactorily transferred to those skilled in the art, and thus the present disclosure may be embodied in other forms and is not limited to the embodiments described below.

In addition, the same or similar elements may be designated by the same reference numerals throughout the specification and in the drawings, the lengths and thickness of layers and regions may be exaggerated for convenience. It will be understood that, where a first element is referred to as being "on" a second element, although the first element may be disposed on the second element so as to come into contact with the second element, a third element may be interposed between the first element and the second element.

Here, terms such as, for example, "first" and "second" may be used to refer to any one element separately from another element. However, the first element and the second element may be arbitrary named according to the convenience of those skilled in the art without departing the technical sprit of the present disclosure.

The terms used in the specification of the present disclosure are merely used to describe particular embodiments and are not intended to limit the scope of the present disclosure. For example, an element described in the singular form is intended to include a plurality of elements unless the context clearly indicates otherwise. In addition, in the specification of the present disclosure, it will be further understood that the terms "comprises" and "includes" specify the presence of stated features, integers, steps, operations, elements, components, and/or combinations thereof, but do not preclude the presence or addition of one or more other features, integers, steps, operations, elements, components, and/or combinations.

And, unless a more limiting term like 'directly' is used, the terms "connected" and "coupled" may include that two components are "connected" or "coupled" through one or more other components located between the two components.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

### (Example Embodiments)

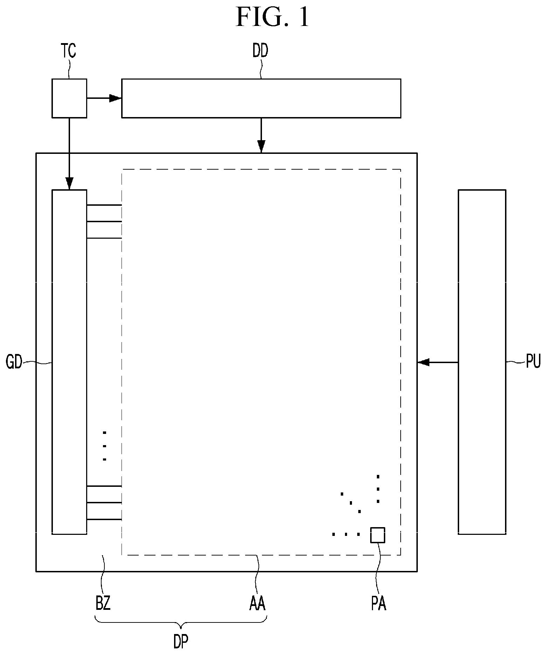

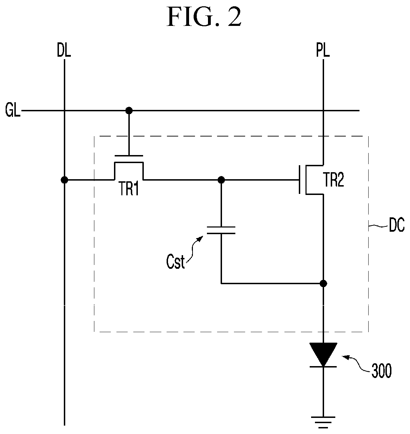

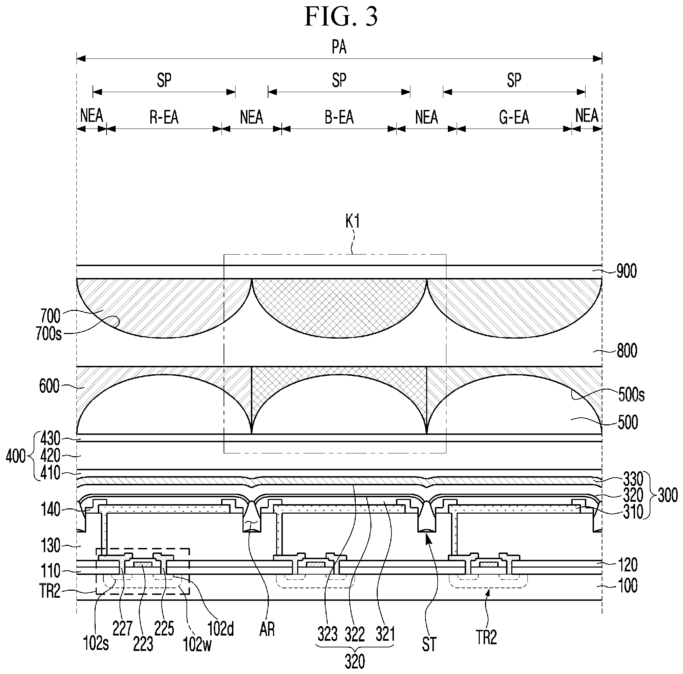

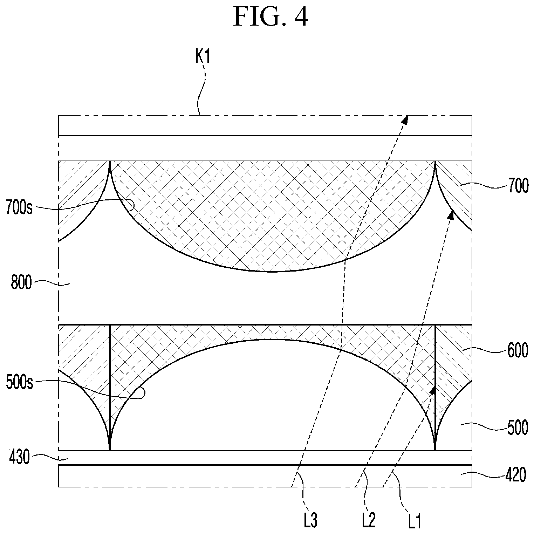

FIG. 1 is a view schematically showing a display apparatus according to an example embodiment of the present disclosure. FIG. 2 is a view showing a circuit of a sub-pixel in the display panel of the display apparatus according to an example embodiment of the present disclosure. FIG. 3 is a view showing a cross-section of a pixel area in the display panel of the display apparatus according to an example embodiment of the present disclosure. FIG. 4 is an enlarged view of K1 region in FIG. 3.

As illustrated in FIGs. 1 to 4, the display apparatus according to the embodiment of the present disclosure can include a display panel DP. The display panel DP can generate an image provided to a user. For example, a plurality of pixel areas PA can be disposed in the display panel DP. Each of the pixel areas PA can realize various colors. For example, each of the pixel areas PA can include a plurality of sub-pixels SP displaying different colors. Various signals can be applied to each sub-pixel SP through signal wirings GL, DL, and PL. For example, the signal wirings GL, DL, and PL can include gate lines GL applying a gate signal, data lines DL applying a data signal, and a power voltage supply lines PL supplying a power voltage.

The gate lines GL can be electrically connected to a gate driver GD. The data lines DL can be electrically connected to a data driver DD. The gate driver GD and the data driver DD can be controlled by a timing controller TC. For example, the gate driver GD can receive clock signals, reset signals and a start signal from the timing controller TC, and the data driver DD can receive digital video data and a source timing signal from the timing controller TC. The power voltage supply lines PL can be electrically connected to a power unit PU.

The display panel DP can include an active area AA and a bezel area BZ. The image provided to the user can be generated in the active area AA. For example, the plurality of pixel areas PA can be disposed in the active area AA of the display panel DP. The bezel area BZ can be disposed outside the active area AA. For example, the active area AA can be surrounded by the bezel area BZ. The gate driver GD, the data driver DD, the timing controller TC, and the power unit PU can be disposed outside the active area AA. For example, each of the signal wirings GL, DL and PL can include a region disposed on the bezel area BZ.

At least one of the gate driver GD, the data driver DD, the timing controller TC and the power unit PU can be disposed on the bezel area BZ. For example, the display apparatus according to the embodiment of the present disclosure can be a GIP (Gate In Panel) type display apparatus in which the gate driver GD is formed in the bezel area BZ.

Each of the sub-pixels SP can emit light displaying a specific color. For example, a driving circuit DC electrically connected to a light-emitting device 300 can be disposed in each sub-pixel SP. The driving circuit DC of each sub-pixel SP can be electrically connected to the signal wirings GL, DL and PL. For example, the driving circuit DC of each sub-pixel SP can generate a driving current corresponding to the data signal according to the gate signal. The driving current generated by the driving circuit DC of each sub-pixel SP can be supplied to the light-emitting device 300 of the corresponding sub-pixel SP for one frame. For example, the driving circuit DC of each sub-pixel SP can include a first thin film transistor TR1, a second thin film transistor TR2, and a storage capacitor Cst.

The driving circuit DC and the light-emitting device 300 of each sub-pixel SP can be supported by a device substrate 100. The device substrate 100 can include various materials. For example, the device substrate 100 can be a wafer made of a semiconductor material, such as silicon. The driving circuit DC of each sub-pixel SP can include a region disposed in the device substrate 100. Thus, in the display apparatus according to the embodiment of the present disclosure, the density of the driving circuit DC in each sub-pixel SP can be improved.

The first thin film transistor TR1 of each sub-pixel SP can transmit the data signal to the second thin film transistor TR2 of the corresponding sub-pixel SP according to the gate signal. For example, the first thin film transistor TR1 of each sub-pixel SP can function as a switching thin film transistor. The first thin film transistor TR1 of each sub-pixel SP can include a first well region, a first drain region, a first source region, a first gate electrode, a first drain electrode and a first source electrode. For example, the first gate electrode of each sub-pixel SP can be electrically connected to the corresponding gate line GL, and the first drain electrode of each sub-pixel SP can be electrically connected to the corresponding data line DL.

The first well region, the first drain region and the first source region can be disposed in the device substrate 100. For example, the first well region, the first drain region and the first source region can be formed by a process of doping a portion of the device substrate 100 with conductive impurities. The first drain region and the first source region can include conductive impurities having a different type from the first well region. For example, the first well region can include a p-type impurity, and the first drain region and the first source region can include a n-type impurity. The first drain region and the first source region can be formed in the first well region. The first source region can be spaced apart from the first drain region.

The first gate electrode can be disposed on the device substrate 100. The first gate electrode can be disposed between the first drain region and the first source region. For example, a portion of the first well region disposed between the first drain region and the first source region can overlap the first gate electrode. The first gate electrode can include a conductive material. For example, the first gate electrode can include a metal, such as aluminum (Al), chromium (Cr), copper (Cu), molybdenum (Mo), titanium (Ti), and tungsten (W). The first gate electrode can be spaced apart from the device substrate 100. The first gate electrode can be insulated from the device substrate 100. For example, the first drain region can be electrically connected to the first source region according to a voltage applied to the first gate electrode. That is, in the display apparatus according to the embodiment of the present disclosure, a portion of the first well region disposed between the first drain region and the first source region can function as a first channel region of the first thin film transistor TR1. Thus, in the display apparatus according to the embodiment of the present disclosure, the electric characteristics of the first thin film transistor TR1 can be improved.

The first drain electrode can be disposed on the device substrate 100. The first drain electrode can be electrically connected to the first drain region. The first drain electrode can include a conductive material. For example, the first drain electrode can include a metal, such as aluminum (Al), chromium (Cr), copper (Cu), molybdenum (Mo), titanium (Ti), and tungsten (W). The first drain electrode can include a different material from the first gate electrode. For example, the first drain electrode can be disposed on a different layer from the first gate electrode. The first drain electrode can be insulated from the first gate electrode.

The first source electrode can be disposed on the device substrate 100. The first source electrode can be electrically connected to the first source region. The first source electrode can include a conductive material. For example, the first source electrode can include a metal, such as aluminum (Al), chromium (Cr), copper (Cu), molybdenum (Mo), titanium (Ti), and tungsten (W). The first source electrode can include a different material from the first gate electrode. For example, the first source electrode can be disposed on a different layer from the first gate electrode. The first source electrode can be insulated from the first gate electrode.

The first source electrode can be disposed on a same layer as the first drain electrode. The first source electrode can be spaced apart from the first drain electrode. The first source electrode can include a same material as the first drain electrode. The first source electrode can be formed by a same process as the first drain electrode. For example, the first source electrode can be formed simultaneously with the first drain electrode. Thus, in the display apparatus according to the embodiment of the present disclosure, the process efficiency can be improved.

The second thin film transistor TR2 of each sub-pixel SP can generate the driving current corresponding to the data signal. For example, the second thin film transistor TR2 of each sub-pixel SP can function as a driving thin film transistor. The second thin film transistor TR2 of each sub-pixel SP can include a second well region 102w, a second drain region 102d, a second source region 102s, a second gate electrode 223, a second drain electrode 225, and a second source electrode 227. For example, the second gate electrode 223 of each sub-pixel SP can be electrically connected to the first source electrode of the corresponding sub-pixel SP, and the second drain electrode 225 of each sub-pixel SP can be electrically connected to the corresponding power voltage supply line PL. The light-emitting device 300 of each sub-pixel SP can be electrically connected to the second source electrode 227 of the corresponding sub-pixel SP.

The second well region 102w, the second drain region 102d, and the second source region 102s can be disposed in the device substrate 100. For example, the second well region 102w, the second drain region 102d, and the second source region 102s can be formed by a process of doping a portion of the device substrate 100 with conductive impurities. The second drain region 102d and the second source region 102s can include conductive impurities having a different type of the second well region 102w. For example, the second well region 102w can include a n-type impurity, and the second drain region 102d, and the second source region 120s can include a p-type impurity. Thus, in the display apparatus according to the embodiment of the present disclosure, the second thin film transistor TR2 of each sub-pixel SP can have different electric characteristics from the first thin film transistor TR1 of each sub-pixel SP. The second drain region 102d and the second source region 102s can be formed in the second well region 102w. The second source region 102s can be spaced apart from the second drain region 102d.

The second well region 102w can include same conductive impurities as the first drain region and the first source region, and the second drain region 102d and the second source region 102s can include same conductive impurities as the first well region. For example, the second well region 102w can be formed simultaneously with the first drain region and the first source region, and the second drain region 102d and the second source region 102s can be formed simultaneously with the first well region. Thus, in the display apparatus according to the embodiment of the present disclosure, the process efficiency can be improved.

The second gate electrode 223 can be disposed on the device substrate 100. The second gate electrode 223 can be disposed between the second drain region 102d and the second source region 102s. For example, a portion of the second well region 102 disposed between the second drain region 102d and the second source region 102s can overlap the second gate electrode 223. The second gate electrode 223 can include a conductive material. For example, the second gate electrode 223 can include a metal, such as aluminum (Al), chromium (Cr), copper (Cu), molybdenum (Mo), titanium (Ti), and tungsten (W). The second gate electrode 223 can be spaced apart from the device substrate 100. The second gate electrode 223 can be insulated from the device substrate 100. For example, a portion of the second well region 102w disposed between the second drain region 102d and the second source region 102s can have an electrical conductivity corresponding to a voltage applied to the second gate electrode 223. That is, in the display apparatus according to the embodiment of the present disclosure, a portion of the second well region 102w overlapping with the second gate electrode 223 can function as a second channel region of the second thin film transistor TR2. Thus, in the display apparatus according to the embodiment of the present disclosure, the electric characteristics of the second thin film transistor TR2 can be improved.

The second gate electrode 223 can be disposed on a same layer as the first gate electrode. The second gate electrode 223 can include a same material as the first gate electrode. The second gate electrode 223 can be formed by a same process as the first gate electrode. For example, the second gate electrode 223 can be formed simultaneously with the first gate electrode. Thus, in the display apparatus according to the embodiment of the present disclosure, the process efficiency can be improved.

The second drain electrode 225 can be disposed on the device substrate 100. The second drain electrode 225 can be electrically connected to the second drain region 102d. The second drain electrode 225 can include a conductive material. For example, the second drain electrode 225 can include a metal, such as aluminum (Al), chromium (Cr), copper (Cu), molybdenum (Mo), titanium (Ti), and tungsten (W). The second drain electrode 225 can include a different material from the second gate electrode. For example, the second drain electrode 225 can be disposed on a different layer from the second gate electrode 223. The second drain electrode 225 can be insulated from the second gate electrode 223.

The second drain electrode 225 can be disposed on a same layer as the first drain electrode. The second drain electrode 225 can include a same material as the first drain electrode. The second drain electrode 225 can be formed by a same process as the first drain electrode. For example, the second drain electrode 225 can be formed simultaneously with the first drain electrode. Thus, in the display apparatus according to the embodiment of the present disclosure, the process efficiency can be improved.

The second source electrode 227 can be disposed on the device substrate 100. The second source electrode 227 can be electrically connected to the second source region 102s. The second source electrode 227 can include a conductive material. For example, the second source electrode 227 can include a metal, such as aluminum (Al), chromium (Cr), copper (Cu), molybdenum (Mo), titanium (Ti), and tungsten (W). The second source electrode 227 can include a different material from the second gate electrode 223. For example, the second source electrode 227 can be disposed on a different layer from the second gate electrode 223. The second source electrode 227 can be insulated from the second gate electrode 223.

The second source electrode 227 can be disposed on a same layer as the second drain electrode 225. The second source electrode 227 can be spaced apart from the second drain electrode 225. The second source electrode 227 can include a same material as the second drain electrode 225. The second source electrode 227 can be formed by a same process as the second drain electrode 225. For example, the second source electrode 227 can be formed simultaneously with the second drain electrode 225. Thus, in the display apparatus according to the embodiment of the present disclosure, the process efficiency can be improved.

The storage capacitor Cst of each sub-pixel SP can maintain the voltage applied to the second gate electrode 223 of the corresponding sub-pixel SP for one frame. For example, the storage capacitor Cst of each sub-pixel SP can be electrically connected to the second gate electrode 223 and the second source electrode 227 in the corresponding sub-pixel SP. The storage capacitor Cst of each sub-pixel SP can have a stacked structure of capacitor electrodes. For example, the storage capacitor Cst of each sub-pixel SP can include a first capacitor electrode electrically connected to the second gate electrode 223 of the corresponding sub-pixel SP and a second capacitor electrode electrically connected to the second source electrode 227 of the corresponding sub-pixel SP. The storage capacitor Cst of each sub-pixel SP can be formed by using a process of forming the first thin film transistor TR1 and the second thin film transistor TR2 in the corresponding sub-pixel SP. For example, the first capacitor electrode of each sub-pixel SP can be formed simultaneously with the second gate electrode 223 of the corresponding sub-pixel SP, and the second capacitor electrode of each sub-pixel SP can be formed simultaneously with the second source electrode 227 of the corresponding sub-pixel SP. Thus, in the display apparatus according to the embodiment of the present disclosure, the process efficiency can be improved.

At least one insulating layer 110, 120, 130, and 140 for preventing unnecessary electrical connection can be disposed on the device substrate 100. For example, a gate insulating layer 110, an interlayer insulating layer 120, a device planarization layer 130, and fences 140 can be disposed on the device substrate 100.

The gate insulating layer 110 can be disposed on the device substrate 100. The first gate electrode and the second gate electrode 223 of each sub-pixel SP can be insulated from the device substrate 100 by the gate insulating layer 110. For example, an upper surface of the device substrate 100 toward the first gate electrode and the second gate electrode 223 of each sub-pixel SP can be covered by the gate insulating layer 110. The first gate electrode and the second gate electrode 223 of each sub-pixel SP can be disposed on the gate insulating layer 110. The gate insulating layer 110 can include an insulating material. For example, the gate insulating layer 110 can include an inorganic insulating material, such as silicon oxide (SiOx) and silicon nitride (SiNx). A distance between the device substrate 100 and the second gate electrode 223 of each sub-pixel SP can be the same as a distance between the device substrate 100 and the first gate electrode of each sub-pixel SP. For example, the gate insulating layer 110 can be a linear insulating layer having a constant thickness.

The interlayer insulating layer 120 can be disposed on the gate insulating layer 110. The first drain electrode and the first source electrode of each sub-pixel SP can be insulated from the first gate electrode of the corresponding sub-pixel SP by the interlayer insulating layer 120. The second drain electrode 225 and the second source electrode 227 of each sub-pixel SP can be insulated from the second gate electrode 223 of the corresponding sub-pixel SP by the interlayer insulating layer 120. For example, the interlayer insulating layer 120 can cover the first gate electrode and the second gate electrode 223 of each sub-pixel SP. The first drain electrode, the first source electrode, the second drain electrode 225 and the second source electrode 227 of each sub-pixel SP can be disposed on the interlayer insulating layer 120. The interlayer insulating layer 120 can include an insulating material. For example, the interlayer insulating layer 120 can include an inorganic insulating material.

The device planarization layer 130 can be disposed on the interlayer insulating layer 120. The device planarization layer 130 can remove a thickness difference due to the driving circuit DC of each sub-pixel SP. For example, an upper surface of the device planarization layer 130 opposite to the device substrate 100 can be flat. The upper surface of the device planarization layer 130 can be parallel to the upper surface of the device substrate 100. The first drain electrode, the first source electrode, the second drain electrode 225 and the second source electrode 227 of each sub-pixel SP can be covered by the device planarization layer 130. The device planarization layer 130 can include an insulating material. The device planarization layer 130 can include a different material from the interlayer insulating layer 120. The device planarization layer 130 can include a material having a relatively high fluidity. For example, the device planarization layer 130 can include an organic insulating material.

The light-emitting device 300 of each sub-pixel SP can be disposed on the device planarization layer 130. The light-emitting device 300 of each sub-pixel SP can generate and emit light corresponding to the driving current generated by the driving circuit DC of the corresponding sub-pixel SP. For example, the light-emitting device 300 of each sub-pixel SP can include a first electrode 310, a light-emitting unit 320, and a second electrode 330, which are sequentially stacked on the device planarization layer 130 of the corresponding sub-pixel SP.

The first electrode 310 can include a conductive material. The first electrode 310 can include a material having high reflectance. For example, the first electrode 310 can include a metal, such as aluminum (Al) and silver (Ag). The first electrode 310 can have a multi-layer structure. For example, the first electrode 310 can have a structure in which a reflective electrode made of a metal can be disposed between transparent electrodes made of a transparent conductive material, such as ITO and IZO.

The light-emitting unit 320 can generate light having luminance corresponding to a voltage difference between the first electrode 310 and the second electrode 330. For example, the light-emitting unit 320 can include an emission material layer (EML). The emission material layer can include an organic emission material, an inorganic emission material or a hybrid emission material. For example, the display apparatus according to the embodiment of the present disclosure can be an organic light emitting display apparatus including an organic emission material.

The light-emitting unit 320 can include a plurality of emission material layers. For example, the light-emitting unit 320 can include a first emission stack 321, a charge generation layer 322, and a second emission stack 323, which are sequentially stacked, and each of the first emission stack 321 and the second emission stack 323 can include at least one emission material layer. The charge generation layer 322 can supply electrons or holes to the first emission stack 321 and the second emission stack 323. For example, each of the first emission stack 321 and the second emission stack 323 can emit light. The emission material layer of the second emission stack 323 can include a different material from the emission material layer of the first emission stack 321. For example, the light generated by the second emission stack 323 can display a different color from the light generated by the first emission stack 321. The light emitted from the light-emitting unit 320 can be the light in which the light generated by the first emission stack 321 and the light generated by the second emission stack 323 are superimposed.

Each of the first emission stack 321 and the second emission stack 323 can include at least one functional layer. The functional layer can be a layer smoothly supplying holes or electrons to the emission material layer. For example, the functional layer can be one of a hole injection layer (HIL), a hole transport layer (HTL), an electron transport layer (ETL), and an electron injection layer (EIL). Thus, in the display apparatus according to the embodiment of the present disclosure, the efficiency of the light-emitting unit 320 can be improved.

The second electrode 330 can include a conductive material. The second electrode 330 can include a different material from the first electrode 310. A transmittance of the second electrode 330 can be larger than a transmittance of the first electrode 310. For example, the second electrode 330 can be a transparent electrode made of a transparent conductive material, such as ITO and IZO, or a translucent electrode in which a metal, such as silver (Ag) and magnesium(Mg) is thinly formed. Thus, in the display apparatus according to the embodiment of the present disclosure, the light generated by the light-emitting unit 320 of each sub-pixel SP can be emitted outside through the second electrode 330 of the corresponding sub-pixel SP.

The first electrode 310 of each sub-pixel SP can be electrically connected to the second source electrode 227 of the corresponding sub-pixel SP. For example, the first electrode 310 of each sub-pixel SP can be in direct contact with the second source electrode 227 of the corresponding sub-pixel SP by penetrating the device planarization layer 130. The light-emitting device 300 of each sub-pixel SP can be controlled independently. For example, the first electrode 310 of each sub-pixel SP can be insulated from the first electrode 310 of adjacent sub-pixel SP. The first electrode 310 of each sub-pixel SP can be spaced apart from the first electrode 310 of adjacent sub-pixel SP. For example, an edge of the first electrode 310 in each sub-pixel can be covered by the fences 140 disposed on the device planarization layer 130. The fences 140 can include an insulating material. For example, the fences 140 can include an inorganic insulating material.

The fences 140 can partially expose the first electrode 310 of each sub-pixel SP. For example, the fences 140 can define an emission area R-EA, B-EA, and G-EA in each sub-pixel SP. A portion of the first electrode 310 overlapping with the emission area R-EA, B-EA, and G-EA of each sub-pixel SP can be in direct contact with the upper surface of the device planarization layer 130. The light-emitting unit 320 and the second electrode 330 of each sub-pixel SP can be stacked on a portion of the first electrode 310 overlapping with the emission area R-EA, B-EA, and G-EA of the corresponding sub-pixel SP. Thus, in the display apparatus according to the embodiment of the present disclosure, the luminance deviation due to the generation location of the light emitted from the emission area R-EA, B-EA, and G-EA of each sub-pixel SP can be prevented or reduced.

The light emitted from the light-emitting device 300 of each sub-pixel SP can display a same color as the light emitted from the light-emitting device 300 of adjacent sub-pixel SP. For example, the light-emitting device 300 of each sub-pixel SP can emit white light. The light-emitting unit 320 of each sub-pixel SP can have a stacked structure same as the light-emitting unit 320 of adjacent sub-pixel SP. For example, the first emission stack 321, the charge generation layer 322, and the second emission stack 323 of each sub-pixel SP can be formed respectively by a same process as the first emission stack 321, the charge generation layer 322, and the second emission stack 323 of adjacent sub-pixel SP. The light-emitting unit 320 of each sub-pixel SP can be formed simultaneously with the light-emitting unit 320 of adjacent sub-pixel SP. Thus, in the display apparatus according to the embodiment of the present disclosure, the process efficiency can be improved.

A region disposed between the emission areas R-EA, B-EA, and G-EA can be defined as a non-emission area NEA. For example, the fences 140 can be disposed on the non-emission area NEA. A separating trench ST can be disposed in the non-emission area NEA. For example, the separating trench ST can be disposed between the fences 140. The separating trench ST can be formed in the device planarization layer 130. For example, the separating trench ST can have a groove shape removed a portion of the device planarization layer 130. The separating trench ST can extend toward the device substrate 100. The light-emitting unit 320 of each sub-pixel SP can be partially spaced apart from the light-emitting unit 320 of adjacent sub-pixel SP by the separating trench ST. For example, the first emission stack 321 and the charge generation layer 322 of each sub-pixel SP can be separated from the first emission stack 321 and the charge generation layer 322 of adjacent sub-pixel SP by the separating trench ST. The second emission stack 323 of each sub-pixel SP can be in direct contact with the second emission stack 323 of adjacent sub-pixel SP. For example, an air-gap AR can be formed in the separating trench ST. Thus, in the display apparatus according to the embodiment of the present disclosure, the leakage of the driving current through the charge generation layer 322 of each sub-pixel SP can be prevented or reduced. Therefore, in the display apparatus according to the embodiment of the present disclosure, the malfunction of the light-emitting device 300 in each sub-pixel SP due to the leakage current can be prevented or reduced.

A voltage applied to the second electrode 330 of each sub-pixel SP can be the same as a voltage applied to the second electrode 330 of adjacent sub-pixel SP. For example, the second electrode 330 of each sub-pixel SP can be electrically connected to the second electrode 330 of adjacent sub-pixel SP. The second electrode 330 of each sub-pixel SP can include a same material as the second electrode 330 of adjacent sub-pixel SP. For example, the second electrode 330 of each sub-pixel SP can be formed simultaneously with the second electrode 330 of adjacent sub-pixel SP. The second electrode 330 of each sub-pixel SP can be in direct contact with the second electrode 330 of adjacent sub-pixel SP. For example, the second electrode 330 of each sub-pixel SP can include a region overlapping with the separating trench ST. Thus, in the display apparatus according to the embodiment of the present disclosure, a process of forming the second electrode 330 of each sub-pixel SP can be simplified. And, in the display apparatus according to the embodiment of the present disclosure, the luminance of the light emitted from the light-emitting device 300 of each sub-pixel SP can be adjusted by the data signal applied to the driving circuit DC of the corresponding sub-pixel SP.

An encapsulation structure 400 can be disposed on the light-emitting device 300 of each sub-pixel SP. The encapsulation structure 400 can prevent or reduce the damage of the light-emitting devices 300 due to external impact and moisture. The encapsulation structure 400 can have a multi-layer structure. For example, the encapsulation structure 400 can include a first encapsulating layer 410, a second encapsulating layer 420 and a third encapsulating layer 430, which are sequentially stacked. The first encapsulating layer 410, the second encapsulating layer 420 and the third encapsulating layer 430 can include an insulating material. The second encapsulating layer 420 can include a different material from the first encapsulating layer 410 and the third encapsulating layer 430. For example, the first encapsulating layer 410 and the third encapsulating layer 430 can be an inorganic encapsulating layer made of an inorganic insulating material, and the second encapsulating layer 420 can be an organic encapsulating layer made of an organic insulating material. A thickness difference due to the light-emitting device 300 of each sub-pixel SP can be removed by the second encapsulating layer 420. For example, an upper surface of the encapsulation structure 400 opposite to the device substrate 100 can be a flat surface. The upper surface of the encapsulation structure 400 can be parallel to the upper surface of the device substrate 100. Thus, in the display apparatus according to the embodiment of the present disclosure, the damage of the light-emitting devices 300 due to the external impact and moisture can be effectively prevented or reduced.

Lower lenses 500 can be disposed on the encapsulation structure 400. The lower lenses 500 can overlap the sub-pixels SP. For example, the emission area R-EA, B-EA, and G-EA of each sub-pixel SP can overlap one of the lower lenses 500. The lower lens 500 on each sub-pixel SP can be disposed on a path of the light emitted from the light-emitting device 300 of the corresponding sub-pixel SP. A surface 500s of each lower lens 500 opposite to the device substrate 100 can have a curved shape. For example, the surface 500s of each lower lens 500 can have a cross-section of convex shape opposite to the device substrate 100. Thus, in the display apparatus according to the embodiment of the present disclosure, the lower lenses 500 can function as a convex lens. That is, in the display apparatus according to the embodiment of the present disclosure, the light emitted from the light-emitting device 300 of each sub-pixel SP can be concentrated by the lower lens 500 of the corresponding sub-pixel SP.

A lower surface of each lower lens 500 toward the device substrate 100 can be flat. For example, a cross-section of each lower lens 500 can have a semicircular shape. The lower surface of each lower lens 500 can be in direct contact with the upper surface of the encapsulation structure 400. A maximum size of the lower lens 500 in each sub-pixel SP can be larger than a size of the emission area R-EA, B-EA, and G-EA defined in the corresponding sub-pixel SP. For example, the lower surface of the lower lens 500 on each sub-pixel SP can have a larger size than the emission area R-EA, B-EA, and G-EA of the corresponding sub-pixel SP. The lower surface of the lower lens 500 on each sub-pixel SP can be continuous with the lower surface of the lower lens 500 on adjacent sub-pixel SP. For example, the outermost region of the lower lens 500 on each sub-pixel SP can be in direct contact with the outermost region of the lower lens 500 on adjacent sub-pixel SP. Thus, in the display apparatus according to the embodiment of the present disclosure, all light emitted from the light-emitting device 300 of each sub-pixel SP can be concentrated by the lower lens 500 of the corresponding sub-pixel SP.

Barrier patterns 600 can be disposed on the lower lenses 500. For example, the surface 500s of each lower lens 500 having a convex shape can be covered by the barrier patterns 600. The barrier patterns 600 can overlap the sub-pixels SP. For example, the barrier pattern 600 of each sub-pixel SP can be in direct contact with the surface 500s of the lower lens 500 having a convex shape on the corresponding sub-pixel SP. The barrier pattern 600 of each sub-pixel SP can have a refractive index smaller than the lower lens 500 of the corresponding sub-pixel SP. Thus, in the display apparatus according to the embodiment of the present disclosure, the light emitted from the light-emitting device 300 of each sub-pixel SP can be refracted inside the emission area R-EA, B-EA, and G-EA defined in the corresponding sub-pixel SP on a boundary of the lower lens 500 and the barrier pattern 600 of the corresponding sub-pixel SP. Therefore, in the display apparatus according to the embodiment of the present disclosure, the amount of the light traveling from the light-emitting device 300 of each sub-pixel SP toward adjacent sub-pixel SP can be reduced by the lower lens 500 and the barrier pattern 600 on the corresponding sub-pixel SP.

The barrier pattern 600 of each sub-pixel SP can include a color material. The color material can mean a material that realizes a specific color by using light passing through it. For example, the color material can include a dye or a pigment. The barrier pattern 600 of each sub-pixel SP can have a larger size than the emission area R-EA, B-EA, and G-EA of the corresponding sub-pixel SP. For example, the barrier pattern 600 of each sub-pixel SP can have a same size as the lower surface of the lower lens 500 on the corresponding sub-pixel SP. A side surface of the barrier pattern 600 on each sub-pixel SP can be in direct contact with a side surface of the barrier pattern 600 on adjacent sub-pixel SP. A boundary of the barrier patterns 600 can be disposed on the non-emission area NEA. Thus, in the display apparatus according to the embodiment of the present disclosure, all light emitted from the light-emitting device 300 of each sub-pixel SP can pass through the barrier pattern 600 of the corresponding sub-pixel SP.

The barrier pattern 600 of each sub-pixel SP can include a color material displaying a color realized by the corresponding sub-pixel. The barrier pattern 600 of each sub-pixel SP can include a color material displaying a different color from the barrier pattern 600 of adjacent sub-pixel SP. For example, each of the sub-pixel SP can include one of a red emission area R-EA realizing a red color, a blue emission area B-EA realizing a blue color, and a green emission area G-EA realizing a green color, and the barrier pattern 600 of each sub-pixel SP can include a dye or a pigment displaying one of the red color, the blue color, and the green color, such that the light passing through the barrier pattern 600 of each sub-pixel SP can display one of the red color, the blue color and the green color. That is, in the display apparatus according to the embodiment of the present disclosure, the light emitted from the light-emitting device 300 of each sub-pixel SP can display a specific color by the barrier pattern 600 of the corresponding sub-pixel SP. Thus, in the display apparatus according to the embodiment of the present disclosure, the light L1 traveling from the light-emitting device 300 of each sub-pixel SP toward the barrier pattern 600 of adjacent sub-pixel SP can be blocked by the barrier patterns 600. For example, the light passing through the barrier pattern 600 on the blue emission area B-EA of each pixel area PA does not pass through the barrier pattern 600 on the red emission area R-EA of the corresponding pixel area PA and the barrier pattern 600 on the green emission area G-EA of the corresponding pixel area PA. Therefore, in the display apparatus according to the embodiment of the present disclosure, the color mixing can be prevented or reduced.

Upper lenses 700 can be disposed on the barrier patterns 600. The upper lenses 700 can overlap the sub-pixels SP. For example, each of the upper lenses 700 can overlap one of the lower lenses 500. The upper lens 700 of each sub-pixel SP can have a larger size than the emission area R-EA, B-EA, and G-EA of the corresponding sub-pixel SP. For example, the maximum size of the upper lens 700 on each sub-pixel SP can have a same as the size of the barrier pattern 600 on the corresponding sub-pixel SP. The outermost region of the upper lens 700 on each sub-pixel SP can be in direct contact with the outermost region of the upper lens 700 of adjacent sub-pixel SP. For example, the maximum size of the upper lens 700 on each sub-pixel SP can be a same as the maximum size of the lower lens 500 on the corresponding sub-pixel SP. Thus, in the display apparatus according to the embodiment of the present disclosure, the light concentrated by the lower lens 500 of each sub-pixel SP can be emitted outside passing through the upper lens 700 of the corresponding sub-pixel SP.

Each of the upper lenses 700 can include a color material. The upper lens 700 of each sub-pixel SP can include a color material displaying a color realized by the corresponding sub-pixel SP. For example, the upper lens 700 of each sub-pixel SP can include a color material displaying a same color as the barrier pattern 600 of the corresponding sub-pixel SP. That is, in the display apparatus according to the embodiment of the present disclosure, the upper lens 700 of each sub-pixel SP can include a color material displaying a different color from the upper lens 700 of adjacent sub-pixel SP. Thus, in the display apparatus according to the embodiment of the present disclosure, the light L2 traveling from the light-emitting device 300 of each sub-pixel SP toward the upper lens 700 of adjacent sub-pixel SP can be blocked by the barrier patterns 600 and the upper lenses 700. For example, the light passing through the barrier pattern 600 on the blue emission area B-EA of each pixel area PA does not pass through the upper lens 700 on the red emission area R-EA of the corresponding pixel area PA and the upper lens 700 on the green emission area G-EA of the corresponding pixel area PA. Therefore, in the display apparatus according to the embodiment of the present disclosure, the color mixing can be effectively prevented or reduced.

The barrier pattern 600 and the upper lens 700 of each sub-pixel SP can include a same color material. For example, the light passing through the barrier pattern 600 on the blue emission area B-EA can have a same peak-wavelength as the light passing through the upper lens 700 on the blue emission area B-EA. Thus, in the display apparatus according to the embodiment of the present disclosure, the color sense can be improved.

A surface 700s of each upper lens 700 toward the device substrate 100 can have a curved shape. For example, the surface 700s of each upper lens 700 can have a cross-section of convex shape toward the device substrate 100. The upper lens 700 of each sub-pixel SP can be spaced apart from the barrier pattern 600 of the corresponding sub-pixel SP. For example, the surface 700s of each upper lens 700 having a convex shape can be covered by a lens planarization layer 800. The lens planarization layer 800 can include an insulating material. The lens planarization layer 800 can include a transparent material. For example, the lens planarization layer 800 can include an organic insulating material. The lens planarization layer 800 can extend between the barrier pattern 600 and the upper lens 700 of each sub-pixel SP. For example, the lens planarization layer 800 can be in direct contact with an upper surface of the barrier pattern 600 opposite to the device substrate 100 and the surface 700s of each upper lens 700 having convex shape.

The lens planarization layer 800 can have a smaller refractive index than each upper lens 700. Thus, in the display apparatus according to the embodiment of the present disclosure, the light L3 passing through the lower lens 500 and the barrier pattern 600 of each sub-pixel SP can be refracted outside the emission area R-EA, B-EA, and G-EA defined in the corresponding sub-pixel SP on a boundary between the upper lens 700 of the corresponding sub-pixel SP and the lens planarization layer 800. That is, in the display apparatus according to the embodiment of the present disclosure, the upper lens 700 of each sub-pixel SP can function as a concave lens. For example, in the display apparatus according to the embodiment of the present disclosure, the light emitted from the light-emitting device 300 of each sub-pixel SP can be concentrated by the lower lens 500 on the corresponding sub-pixel SP, and the light concentrated by the lower lens 500 of each sub-pixel SP can be diffused by the upper lens 700 on the corresponding sub-pixel SP. Therefore, in the display apparatus according to the embodiment of the present disclosure, the viewing angle of the light emitted from each sub-pixel SP can be expanded by the upper lens 700 of the corresponding sub-pixel SP.

An upper surface of each upper lens 700 opposite to the device substrate 100 can be flat. For example, a cross-section of each upper lens 700 can have a semicircular shape. The upper lens 700 of each sub-pixel SP can have a shape corresponding to the lower lens 500 of the corresponding sub-pixel SP. For example, the upper surface of the upper lens 700 on each sub-pixel SP can be parallel to the lower surface of the lower lens 500 on the corresponding sub-pixel SP. The upper surface of the upper lens 700 on each sub-pixel SP can be continuous with the upper surface of the upper lens 700 on adjacent sub-pixel SP. Thus, in the display apparatus according to the embodiment of the present disclosure, the light passing through the upper lens 700 of each sub-pixel can have a same viewing angle. Therefore, in the display apparatus according to the embodiment of the present disclosure, the decrease in the quality of the image due to a different in the viewing angle of each sub-pixel SP can be prevented.

A lens passivation layer 900 can be disposed on the upper lenses 700. The lens passivation layer 900 can prevent or reduce the damage of the upper lenses 700 due to the external impact and moisture. The lens passivation layer 900 can include an insulating material. For example, the lens passivation layer 900 can include an inorganic insulating material.

Accordingly, the display apparatus according to the embodiment of the present disclosure can comprise the lower lenses 500, the barrier patterns 600, and the upper lenses 700 on the light-emitting device 300 of each sub-pixel SP, wherein the lower lens 500 of each sub-pixel SP that functions as a convex lens and the upper lens 700 of each sub-pixel SP that functions as a concave lens can have a convex shape toward each other, wherein the surface 500s of the lower lens 500 having a convex shape on each sub-pixel SP can be covered by the barrier pattern 600 of the corresponding sub-pixel SP, and wherein the barrier pattern 600 and the upper lens 700 of each sub-pixel SP can include a color material displaying a same color as the corresponding sub-pixel SP. Thus, in the display apparatus according to the embodiment of the present disclosure, the color mixing can be prevented or reduced, and the viewing angle of the light emitted from the light-emitting device 300 of each sub-pixel SP can be expanded. Therefore, in the display apparatus according to the embodiment of the present disclosure, the change in the quality of the image according to the location of the user can be reduced.

And, in the display apparatus according to the embodiment of the present disclosure, the barrier pattern 600 and the upper lens 700 of each sub-pixel SP can function as a color filter. That is, in the display apparatus according to the embodiment of the present disclosure, a process of forming color filters and a black matrix can be omitted. Thus, in the display apparatus according to the embodiment of the present disclosure, the decrease in the process efficiency due to the formation of the barrier patterns 600 and the upper lenses 700 can be minimized. Therefore, in the display apparatus according to the embodiment of the present disclosure, the production energy can be reduced by the process optimization.

The display apparatus according to the embodiment of the present disclosure is described that the driving circuit DC of each sub-pixel SP consists of the first thin film transistor TR1, the second thin film transistor TR2 and the storage capacitor Cst. However, in the display apparatus according to another embodiment of the present disclosure, the driving circuit DC of each sub-pixel SP can include a driving thin film transistor and at least one switching thin film transistor. For example, in the display apparatus according to another embodiment of the present disclosure, the driving circuit DC of each sub-pixel SP can further include a third thin film transistor to initialize the storage capacitor Cst of the corresponding sub-pixel SP according to the gate signal. The third thin film transistor of each sub-pixel SP can include a third well region, a third drain region, a third source region, a third gate electrode, a third drain electrode, and a third source electrode. The third well region, the third drain region, and the third source region can be formed in the device substrate 100. The third gate electrode of each sub-pixel SP can be electrically connected to the corresponding gate line GL, the third drain electrode of each sub-pixel SP can be electrically connected to an initial line applying an initial signal, and the third source electrode of each sub-pixel SP can be electrically connected to the storage capacitor Cst of the corresponding sub-pixel SP. Thus, in the display apparatus according to another embodiment of the present disclosure, the degree of freedom in the configuration of each driving circuit DC can be improved.

In the display apparatus according to the embodiment of the present disclosure, the location and the electric connection of the first drain electrode, the first source electrode, the second drain electrodes 225, and the second source electrode 227 of each driving circuit DC can vary depending on the configuration of the corresponding driving circuit DC and/or the type of the corresponding thin film transistors TR1 and TR2. For example, in the display apparatus according to another embodiment of the present disclosure, the second gate electrode 223 of each driving circuit DC can be electrically connected to the first drain electrode of the corresponding driving circuit DC. Thus, in the display apparatus according to another embodiment of the present disclosure, the degree of freedom in the configuration of each driving circuit DC and the type of each thin film transistor TR1 and TR2 can be improved.

The display apparatus according to the example embodiment of the present disclosure is described that the first well region, the second drain region 102d, and the second source region 102s of each sub-pixel SP include a p-type impurity, and the first drain region, the first source region and the second well region 102w of each sub-pixel SP include a n-type impurity. However, in the display apparatus according to another example embodiment of the present disclosure, the second well region 102w of each sub-pixel SP can include a same type impurity as the first well region of the corresponding sub-pixel SP. For example, in the display apparatus according to another embodiment of the present disclosure, the first well region and the second well region 102w of each sub-pixel SP can include a p-type impurity. The first drain region, the first source region, the second drain region 102d and the second source region 102s of each sub-pixel SP can include a n-type impurity. Thus, in the display apparatus according to another embodiment of the present disclosure, the degree of freedom in the configuration of each driving circuit DC and the type of each thin film transistor TR1 and TR2 can be improved.

The display apparatus according to the above example embodiment of the present disclosure is described that the device substrate 100 is a wafer formed of a semiconductor material, such as silicon. However, in the display apparatus according to another example embodiment of the present disclosure, the device substrate 100 can include glass or plastic. In the display apparatus according to another embodiment of the present disclosure, the driving circuit DC of each sub-pixel SP can be formed on the upper surface of the device substrate 100. For example, in the display apparatus according to another embodiment of the present disclosure, a buffer layer including an inorganic insulating material, such as silicon oxide (SiOx) and silicon nitride (SiNx) can be formed on the upper surface of the device substrate 100, and each of the first thin film transistor TR1 and the second thin film transistor TR2 of each sub-pixel SP can include a semiconductor pattern formed on the buffer layer. The semiconductor pattern can include a semiconductor material. For example, a first semiconductor pattern of the first thin film transistor TR1 and a second semiconductor pattern of the second thin film transistor TR2 in each sub-pixel SP can include an oxide semiconductor, such as IGZO. Thus, in the display apparatus according to another embodiment of the present disclosure, the degree of freedom in the material of the device substrate 100 and the configuration of each driving circuit DC can be improved.

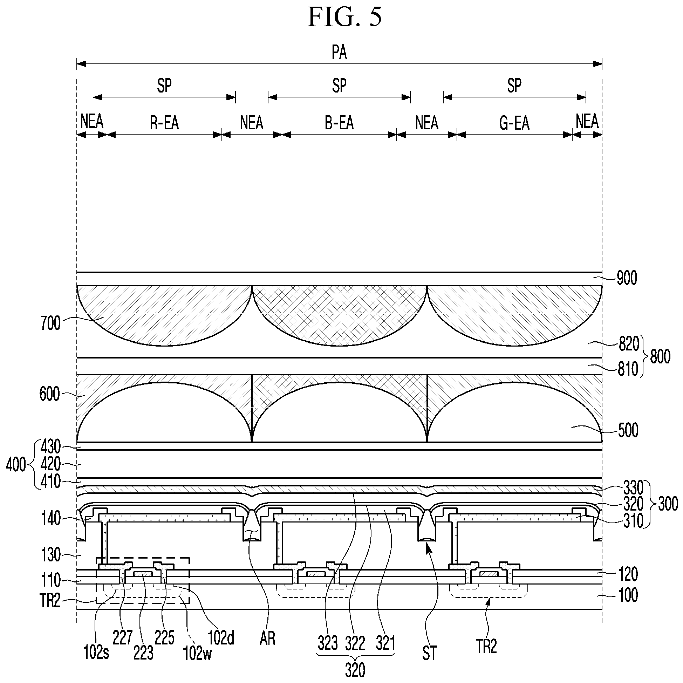

The display apparatus according to the above example embodiment of the present disclosure is described that the lens planarization layer 800 has a single-layer structure. However, in the display apparatus according to another example embodiment of the present disclosure, the lens planarization layer 800 can have a multi-layer structure. For example, in the display apparatus according to another embodiment of the present disclosure, the lens planarization layer 800 can include a first planarization layer 810 disposed on the barrier patterns 600 and a second planarization layer 820 disposed on the first planarization layer 810, as shown in FIG. 5. The surface of each upper lens 700 having a convex shape can be in direct contact with the second planarization layer 820. For example, the second planarization layer 820 can have a smaller refractive index than each upper lens 700.

The first planarization layer 810 can include a different material from the second planarization layer 820. For example, a refractive index of the first planarization layer 810 can be between a refractive index of each barrier pattern 600 and a refractive index of the second planarization layer 820. Thus, in the display apparatus according to another embodiment of the present disclosure, the loss of the light due to a difference in a refractive index of each barrier pattern 600 and the second planarization layer 820 can be prevented or reduced. Therefore, in the display apparatus according to another embodiment of the present disclosure, the decrease in the light extraction efficiency and the color mixing can be prevented or reduced, and the viewing angle of the light emitted from the light-emitting device 300 of each sub-pixel SP can be expanded.

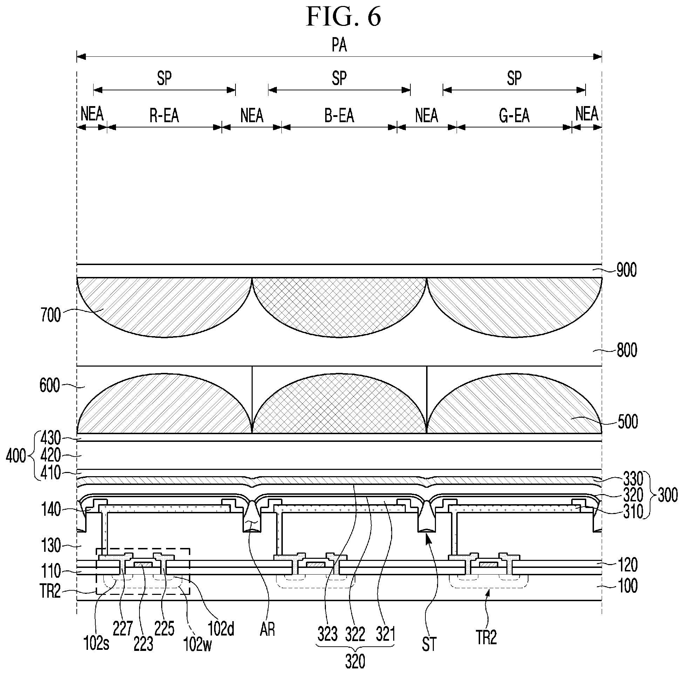

The display apparatus according to the above example embodiment of the present disclosure is described that the barrier pattern 600 of each sub-pixel SP includes a color material. However, as showed in FIG. 6, in the display apparatus according to another example embodiment of the present disclosure, the barrier pattern 600 of each sub-pixel SP can be made of a transparent material, and the lower lens 500 of each sub-pixel SP can include a color material displaying a same color as the upper lens 700 of the corresponding sub-pixel SP. For example, in the display apparatus according to another embodiment of the present disclosure, the lower lens 500 of each sub-pixel SP can be formed of a same material as the upper lens 700 of the corresponding sub-pixel SP. Thus, in the display apparatus according to another embodiment of the present disclosure, the light passing through the lower lens 500 of each sub-pixel SP can display a specific color. That is, in the display apparatus according to another embodiment of the present disclosure, the light passing through the lower lens 500 of each sub-pixel SP can be blocked by the upper lens 700 of adjacent sub-pixel SP. Thus, in the display apparatus according to another embodiment of the present disclosure, the viewing angle of the light passing through the lower lens 500 of each sub-pixel SP can be expanded, and the color mixing can be prevented or reduced.

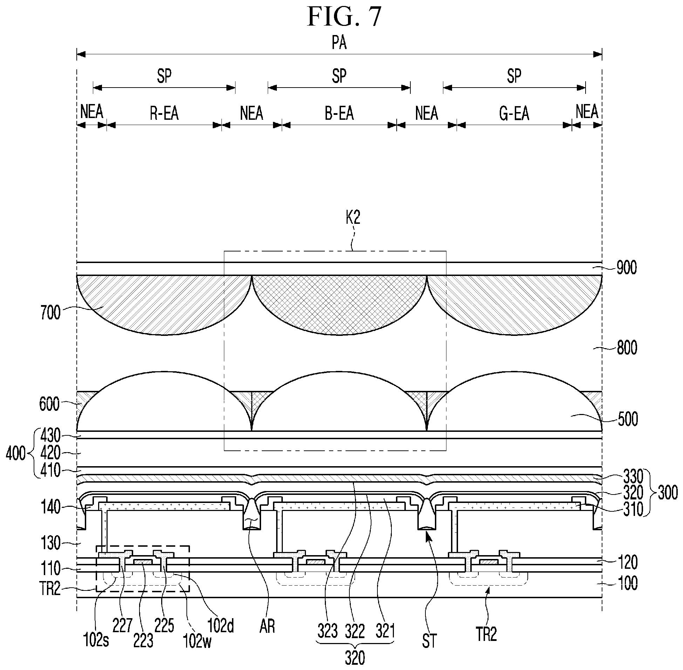

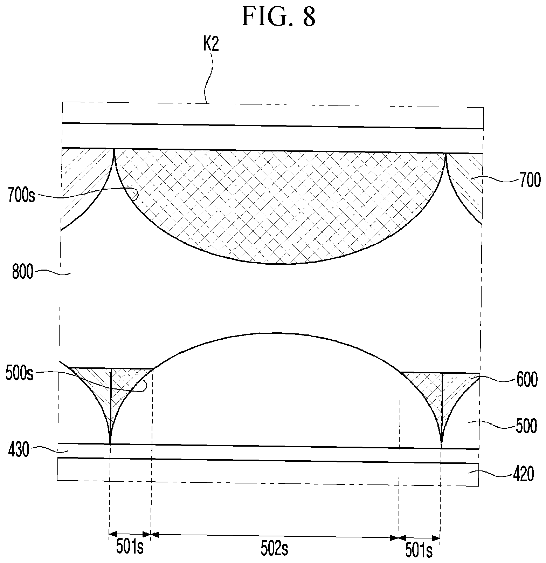

The display apparatus according to the above example embodiment of the present disclosure is described that the surface of the lower lens 500 having a convex shape on each sub-pixel SP is covered by the barrier pattern 600 of the corresponding sub-pixel SP. However, in the display apparatus according to another example embodiment of the present disclosure, a thickness of the barrier pattern 600 on each sub-pixel SP can be smaller than the maximum thickness of the lower lens 500 on the corresponding sub-pixel SP. For example, in the display apparatus according to another embodiment of the present disclosure, the surface 500s of the lower lens 500 having a convex shape on each sub-pixel SP can include a first region 501s in contact with the barrier pattern 600 of the corresponding sub-pixel SP and a second region 502s in contact with the lens planarization layer 800, as shown in FIGs. 7 and 8. FIG. 8 is an enlarged view of K2 region in FIG. 7. The lens planarization layer 800 can have a smaller refractive index than each lower lens 500. The second region 502s of the lower lens 500 on each sub-pixel SP can be disposed close to the center of the emission area R-EA, B-EA, and G-EA defined in the corresponding sub-pixel SP. For example, the first region 501s of the lower lens 500 on each sub-pixel SP can overlap the non-emission area NEA. That is, in the display apparatus according to another embodiment of the present disclosure, the barrier pattern 600 of each sub-pixel SP can be disposed outside the emission area R-EA, B-EA, and G-EA defined in the corresponding sub-pixel SP. Thus, in the display apparatus according to another embodiment of the present disclosure, the color mixing can be prevented or reduced, and the luminance of the light emitted from each sub-pixel SP can be improved.

In the display apparatus according to the above example embodiment of the present disclosure, the barrier pattern 600 of one of the sub-pixels SP can include a color material displaying a different color from the upper lens 700 of the corresponding sub-pixel SP and the upper lens 700 of adjacent sub-pixel SP. For example, in the display apparatus according to another example embodiment of the present disclosure, the blue emission area B-EA of each pixel area PA can be disposed between the red emission area R-EA and the green emission area G-EA of the corresponding pixel area PA, the barrier pattern 600 on the red emission area R-EA of each pixel area PA can include a dye or a pigment displaying a green color, the barrier pattern 600 on the green emission area G-EA of each pixel area PA can include a dye or a pigment displaying a red color, and the barrier pattern 600 of the blue emission area B-EA of each pixel area PA can include a dye or a pigment displaying a blue color. Thus, in the display apparatus according to another embodiment of the present disclosure, the decrease in the light extraction efficiency and the color mixing can be effectively prevented. And, in the display apparatus according to another embodiment of the present disclosure, the degree of freedom in the shape and the material of the barrier patterns 600 can be improved.

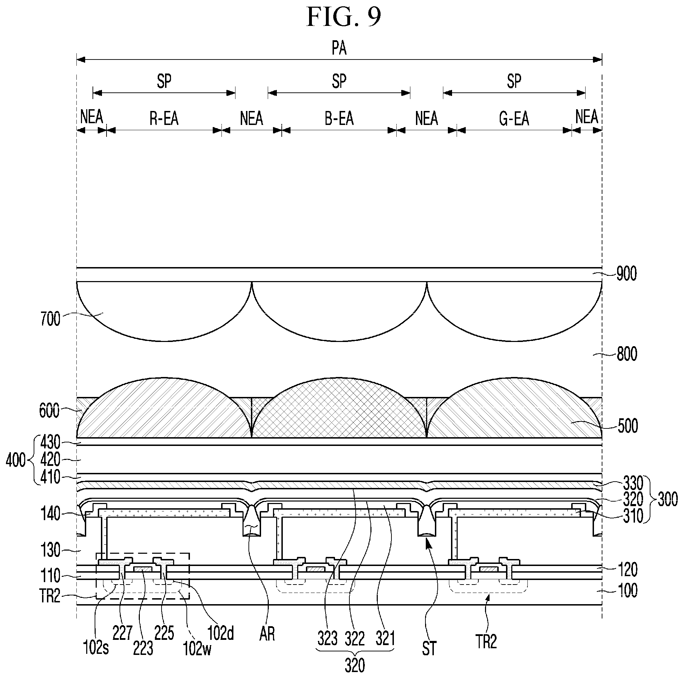

The display apparatus according to the above example embodiment of the present disclosure is described that the barrier pattern 600 and the upper lens 700 of each sub-pixel SP include a color material. However, in the display apparatus according to another example embodiment of the present disclosure, the upper lens 700 of each sub-pixel SP can be made of a transparent material. For example, in the display apparatus according to another embodiment of the present disclosure, the lower lens 500 of each sub-pixel SP can include a color material displaying a same color as the corresponding sub-pixel SP, a thickness of the barrier pattern 600 on each sub-pixel SP can be smaller than the maximum thickness of the lower lens 500 on the corresponding sub-pixel SP, and the barrier pattern 600 of at least one of the sub-pixels SP can include a color material displaying a different color from the lower lens 500 of the corresponding sub-pixel SP, as shown in FIG. 9. For example, the barrier pattern 600 of at least one of the sub-pixels SP can include a color material displaying a different color from the lower lens 500 of the corresponding sub-pixel SP and the lower lens 500 of adjacent sub-pixel SP. Thus, in the display apparatus according to another embodiment of the present disclosure, the color mixing can be prevented or reduced by the lower lens 500 and the barrier pattern 600 of each sub-pixel SP, the viewing angle of the light emitted from the light-emitting device of each sub-pixel SP can be expanded by the upper lens 700 of the corresponding sub-pixel SP. Therefore, in the display apparatus according to the embodiment of the present disclosure, the reduction in the viewing angle of the light emitted from the light-emitting device 300 of each sub-pixel SP can be minimized, and the color mixing can be effectively prevented or reduced.

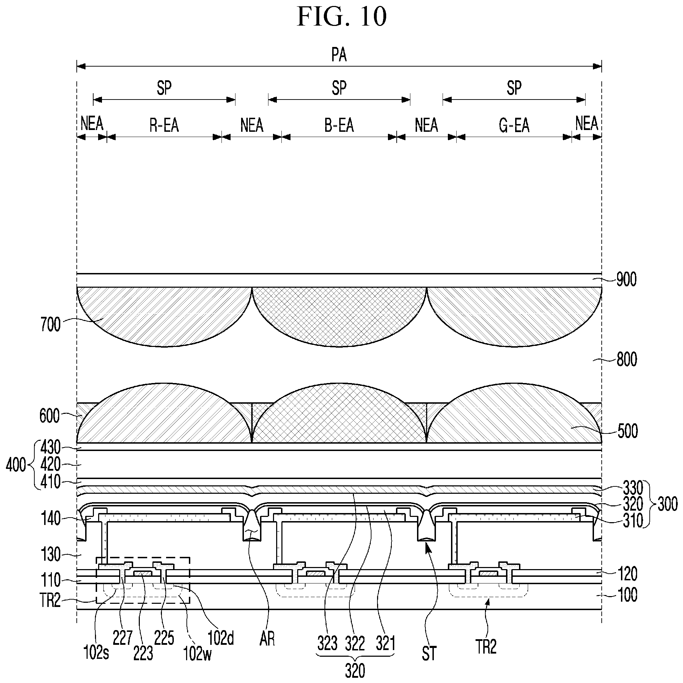

In the display apparatus according to another embodiment of the present disclosure, the lower lens 500, the barrier pattern 600 and the upper lens 700 of each sub-pixel SP can include a color material. For example, as shown in FIG. 10, in the display apparatus according to another embodiment of the present disclosure, the lower lens 500 of each sub-pixel SP can include a color material displaying a same color as the upper lens 700 of the corresponding sub-pixel SP, the barrier pattern 600 of at least one of the sub-pixels SP can include a color material displaying a different color from the lower lens 500 of the corresponding sub-pixel SP, and a thickness of the barrier pattern 600 on each sub-pixel SP can be smaller than the maximum thickness of the lower lens 500 on the corresponding sub-pixel SP. For example, the barrier pattern 600 of at least one of the sub-pixels SP can include a color material displaying a different color from the upper lens 700 and the lower lens 500 of the corresponding sub-pixel SP and the upper lens 700 and the lower lens 500 of adjacent sub-pixel SP. Thus, in the display apparatus according to another embodiment of the present disclosure, the color sense of the light emitted from the light-emitting device 300 of each sub-pixel SP can be improved, and the color mixing can be prevented or reduced.

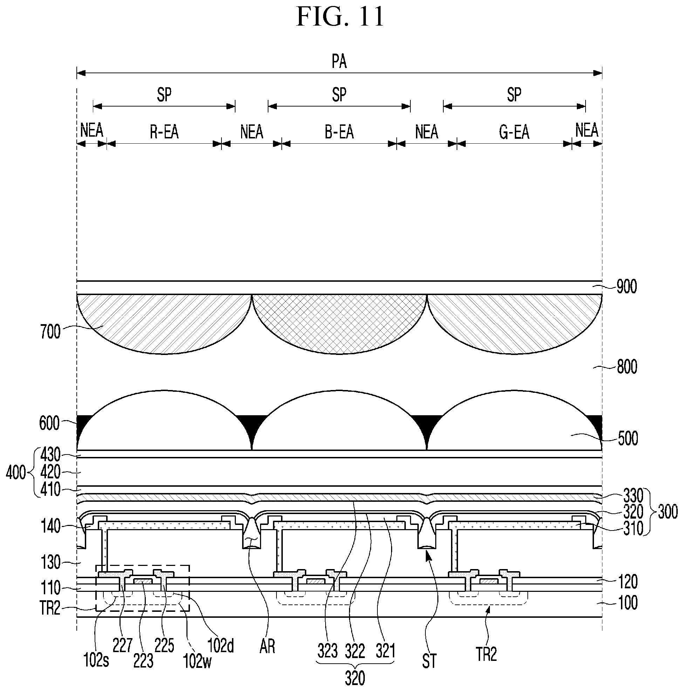

The display apparatus according to the above example embodiment of the present disclosure is described that the barrier pattern 600 of each sub-pixel SP includes a different color material from the barrier pattern 600 of adjacent sub-pixel SP. However, in the display apparatus according to another example embodiment of the present disclosure, the barrier pattern 600 of each sub-pixel SP can include a same color material as the barrier pattern 600 of adjacent sub-pixel SP. For example, as shown in FIG. 11, in the display apparatus according to another embodiment of the present disclosure, the barrier pattern 600 of each sub-pixel SP can include a color material displaying a black color, and a thickness of the barrier pattern 600 on each sub-pixel SP can be smaller than the maximum thickness of the lower lens 500 on the corresponding sub-pixel SP. The lower lens 500 of each sub-pixel SP can include a region in contact with the lens planarization layer 800, and the lens planarization layer 800 can have a smaller refractive index than each lower lens 500. The color material displaying a black color can include a carbon black. That is, in the display apparatus according to another embodiment of the present disclosure, the barrier patterns 600 can function as a black matrix. Therefore, in the display apparatus according to another embodiment of the present disclosure, the degree of freedom in the material of the barrier pattern 600 for preventing or reducing the color mixing can be improved.

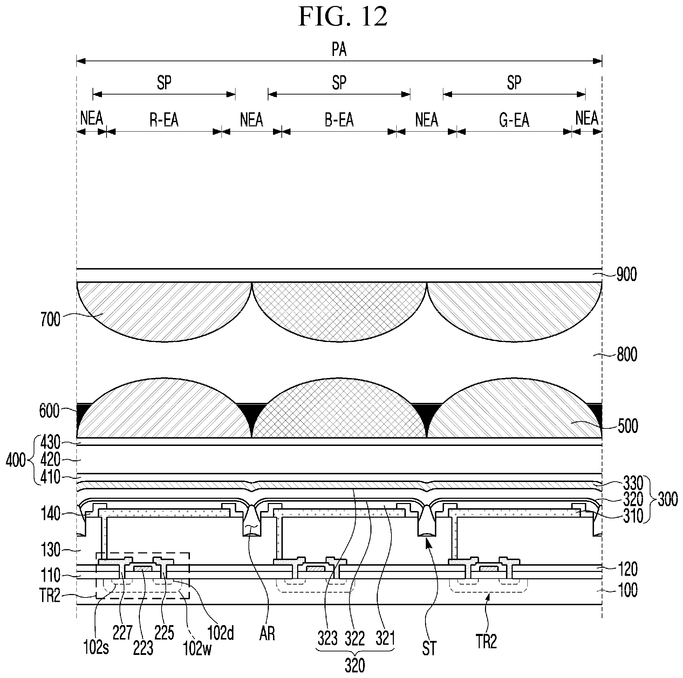

As shown in FIG. 12, in the display apparatus according to another embodiment of the present disclosure, the barrier pattern 600 of each sub-pixel SP can include a color material displaying a black color, a thickness of the barrier pattern 600 on each sub-pixel SP can be smaller than the maximum thickness of the lower lens 500 on the corresponding sub-pixel SP, and the lower lens 500 of each sub-pixel SP can include a color material displaying a same color as the upper lens 700 of the corresponding sub-pixel SP. That is, in the display apparatus according to another embodiment of the present disclosure, the lower lens 500 of each sub-pixel SP can function as a first color filter, the barrier pattern 600 of each sub-pixel SP can function as a black matrix, and the upper lens 700 of each sub-pixel SP can function as the second color filter. Thus, in the display apparatus according to another embodiment of the present disclosure, the color sense of the light emitted from the light-emitting device 300 of each sub-pixel SP can be improved, and the color mixing can be effectively prevented or reduced.

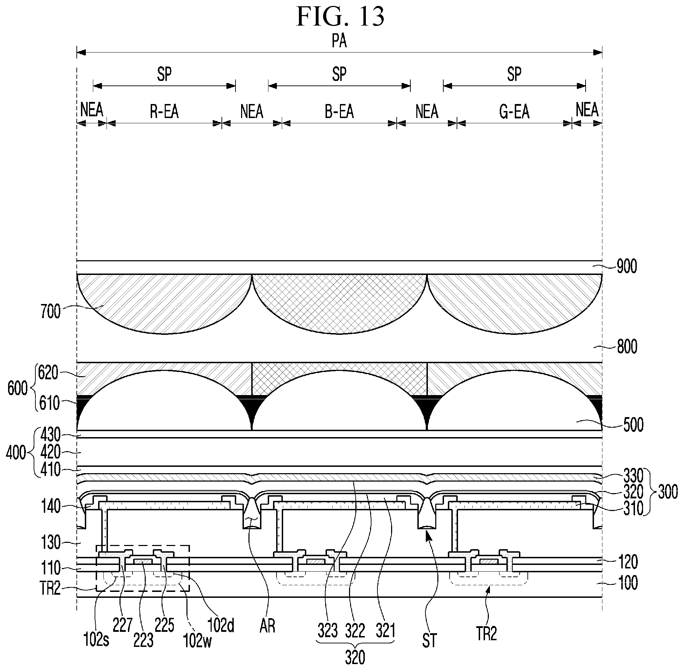

The display apparatus according to the above example embodiment of the present disclosure is described that the barrier pattern 600 of each sub-pixel SP has a single-layer structure. However, in the display apparatus according to another example embodiment of the present disclosure, the barrier pattern 600 of each sub-pixel SP can have a multi-layer structure. For example, in the display apparatus according to another embodiment of the present disclosure, the barrier pattern 600 of each sub-pixel SP can include a first pattern layer 610 including a color material displaying a black color and a second pattern layer 620 disposed on the first pattern layer 610, as shown in FIG. 13. The second pattern layer 620 can include a color material displaying a different color from the first pattern layer 610. For example, the second pattern layer 620 of each sub-pixel SP can include a color material displaying a same color as the upper lens 700 of the corresponding sub-pixel SP. The surface of the lower lens 500 having a convex shape on each sub-pixel SP can include a region in contact with the first pattern layer 610 and a region in contact with the second pattern layer 620. For example, the first pattern layer 610 of each sub-pixel SP can be in contact with an edge of the lower lens 500 on the corresponding sub-pixel SP, and the second pattern layer 620 of each sub-pixel SP can be in contact with the central portion of the lower lens 500 on the corresponding sub-pixel SP. Thus, in the display apparatus according to another embodiment of the present disclosure, the reduction in the viewing angle of the light emitted from the light-emitting device 300 of each sub-pixel SP can be minimized, and the color mixing can be effectively prevented or reduced.

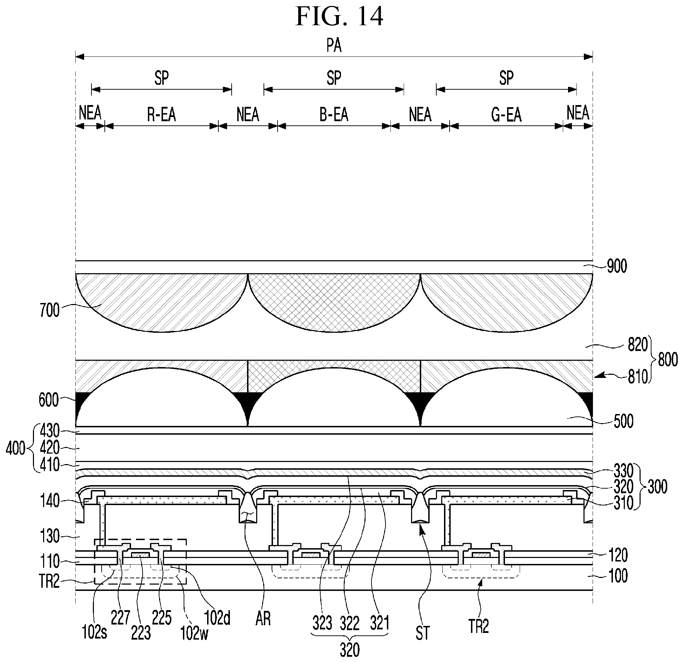

The display apparatus according to the above example embodiment of the present disclosure is described that the lens planarization layer 800 does not include a color material. However, in the display apparatus according to another example embodiment of the present disclosure, a portion of the lens planarization layer 800 overlapping with each sub-pixel SP can include a color material corresponding to a color realized by the corresponding sub-pixel SP. For example, in the display apparatus according to another embodiment of the present disclosure, an edge of the lower lens 500 on each sub-pixel SP can be surrounded by the barrier pattern 600 of the corresponding sub-pixel SP, the lens planarization layer 800 can include a first planarization layer 810 in direct contact with the center of the lower lens 500 on each sub-pixel SP and a second planarization layer 820 disposed on the first planarization layer 810, and a portion of the first planarization layer 810 overlapping with each sub-pixel SP can include a color material displaying a same color as the corresponding sub-pixel SP, as shown in FIG. 14. Thus, in the display apparatus according to another embodiment of the present disclosure, the color mixing can be prevented or reduced by a portion of the first planarization layer 810 and the upper lens 700 on each sub-pixel SP. For example, the first planarization layer 810 of each sub-pixel SP may include another color material displaying a same color as the color material of the upper lens 700 of the corresponding sub-pixel SP. Therefore, in the display apparatus according to another embodiment of the present disclosure, the degree of freedom in the configuration of the barrier patterns 600 and the lens planarization layer 800 can be improved.

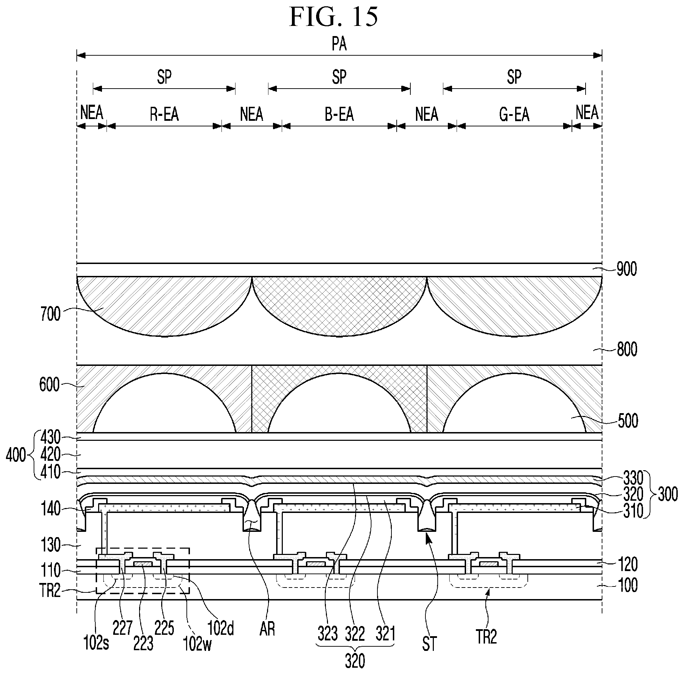

The display apparatus according to the above example embodiment of the present disclosure is described that the upper lens 700 of each sub-pixel SP has the maximum size same as the lower lens 500 of the corresponding sub-pixel SP. However, in the display apparatus according to another example embodiment of the present disclosure, the surface 700s of the upper lens 700 having a convex shape on each sub-pixel SP can have a different curvature from the surface 500s of the lower lens 500 having a convex shape on the corresponding sub-pixel SP. For example, in the display apparatus according to another embodiment of the present disclosure, the maximum size of the lower lens 500 on each sub-pixel SP can be smaller than the maximum size of the upper lens 700 on the corresponding sub-pixel SP, as shown in FIG. 15. The surface of the upper lens 700 having a convex shape on each sub-pixel SP can have a larger curvature than the surface of the lower lens 500 having a convex shape. Thus, in the display apparatus according to another embodiment of the present disclosure, the light emitted from an edge of the lower lens 500 on each sub-pixel SP can be refracted toward the upper lens 700 of the corresponding sub-pixel SP by a difference in the refractive index of the lower lens 500 and the barrier pattern 600 of the corresponding sub-pixel SP. That is, in the display apparatus according to another embodiment of the present disclosure, the amount of the light travelling toward the upper lens 700 of each sub-pixel SP can be increased. Therefore, in the display apparatus according to another embodiment of the present disclosure, the luminance of the light emitted from each sub-pixel SP can be improved, and the color mixing can be prevented or reduced.

In the result, the display apparatus according to example embodiments of the present disclosure can comprise the lower lens, the barrier pattern and the upper lens disposed on the light-emitting device, wherein the lower lens and the upper lens can have the surface of convex shape toward each other, wherein the surface of the lower lens having a convex shape can be partially surrounded by the barrier pattern, and wherein at least two of the lower lens, the barrier pattern and the upper lens can include a color material. Thus, in the display apparatus according to example embodiments of the present disclosure, the reduction in the viewing angle of the light emitted from each light-emitting device can be minimized, and the color mixing can be prevented or reduced. Thereby, in the display apparatus according to example embodiments of the present disclosure, the change in the quality of the image according to the location of the user can be minimized. And, in the display apparatus according to example embodiments of the present disclosure, the production energy can be reduced by the process optimization.

## Claims

1. A display apparatus, comprising:
a device substrate (100);
a light-emitting device (300) on an emission area (R-EA, B-EA, G-EA) of the device substrate (100);
a lower lens (500) on the light-emitting device (300), the lower lens (500) overlapping with the emission area (R-EA, B-EA, G-EA);
a barrier pattern (600) on the light-emitting device (300), the barrier pattern (600) surrounding an edge of the lower lens (500); and
an upper lens (700) on the lower lens (500) and the barrier pattern (600), the upper lens (700) overlapping with the emission area (R-EA, B-EA, G-EA),
wherein a surface (500s) of the lower lens (500) toward the upper lens (700) and a surface (700s) of the upper lens (700) toward the lower lens (500) have a cross-section of convex shape, and
wherein one of the lower lens (500) and the barrier pattern (600) includes a color material displaying a same color as the upper lens (700).

2. The display apparatus of claim 1, wherein the color material includes a dye or a pigment displaying one of a red color, a green color, and a blue color.

3. The display apparatus of claim 1 or 2, wherein a refractive index of the barrier pattern (600) is smaller than a refractive index of the lower lens (500).

4. The display apparatus of claim 3, wherein a thickness of the barrier pattern (600) is larger than a maximum thickness of the lower lens (500), and
wherein the surface (500s) of the lower lens (500) toward the upper lens (700) is in contact with the barrier pattern (600).

5. The display apparatus of any of claims 1 to 4, further comprising a lens planarization layer (800) in contact with the surface (700s) of the upper lens (700) toward the lower lens (500),
wherein a refractive index of the lens planarization layer (800) is smaller than a refractive index of the upper lens (700),
wherein, preferably, a surface of the lens planarization layer (800) toward the device substrate (100) is in contact with a surface of the barrier pattern (600) opposite to the device substrate (100).

6. The display apparatus of any of claims 1 to 5, wherein each of the lower lens (500) and the upper lens (700) has a larger size than the emission area (R-EA, B-EA, G-EA),
wherein, preferably, a size of the upper lens (700) is different from a size of the lower lens (500).

7. The display apparatus according to any of claims 1 to 4, further comprising a lens planarization layer (800) which includes a first planarization layer (810) provided on the barrier pattern (600) and a second planarization layer (820) provided between the first planarization layer (810) and the upper lens (700),
wherein a refractive index of the first planarization layer (810) is between a refractive index of the barrier pattern (600) and a refractive index of the second planarization layer (820), and the second planarization layer (820) has a smaller refractive index than the upper lens (700).

8. A display apparatus, comprising:
a device substrate (100);
a light-emitting device (300) on an emission area (R-EA, B-EA, G-EA) of the device substrate (100);
a lower lens (500) on the light-emitting device (300), the lower lens (500) having a first curved surface (500s) on a side opposite to the device substrate (100);
a barrier pattern (600) surrounding at least a portion of the first curved surface (500s),
the barrier pattern (600) including a first color material; and
an upper lens (700) on the lower lens (500) and the barrier pattern (600), the upper lens (700) having a second curved surface (700s) toward the first curved surface (500s),
wherein the first curved surface (500s) and the second curved surface (700s) overlapping with the emission area (R-EA, B-EA, G-EA) have a convex shape toward each other, and
wherein at least one of the lower lens (500) and the upper lens (700) includes a second color material displaying a different color from the first color material.

9. The display apparatus of claim 8, wherein the barrier pattern (600) is disposed outside the emission area (R-EA, B-EA, G-EA).

10. The display apparatus of claim 8 or 9, further comprising a lens planarization layer (800) disposed between the lower lens (500) and the upper lens (700),
wherein the lens planarization layer (800) has a refractive index smaller than a refractive index of the lower lens (500),
wherein the first curved surface (500s) of the lower lens (500) includes a first region (501s) in contact with the barrier pattern (600) and a second region (502s) in contact with the lens planarization layer (800), and
wherein the second region (502s) is disposed closer to a center of the emission area (R-EA, B-EA, G-EA) than the first region (501s).

11. The display apparatus of claim 10, wherein the first color material includes a dye or a pigment displaying a black color.

12. The display apparatus of any of claims 8 to 11, wherein an upper surface of the upper lens (700) opposite to the device substrate (100) is parallel to a lower surface of the lower lens (500) toward the device substrate (100).

13. The display apparatus of claim 8 or 9, further comprising a lens planarization layer (800), wherein the lens planarization layer (800) includes a first planarization layer (810) and a second planarization layer (820) disposed on the first planarization layer (810),
wherein the first planarization layer (810) includes a third color material displaying a same color as the second color material.

14. The display apparatus of any of claims 8 to 13, wherein the second curved surface (700s) of the upper lens (700) has a different curvature from the first curved surface (500s) of the lower lens (500).

15. The display apparatus according to any of claims 8 to 14, wherein the display apparatus includes a plurality of sub-pixels (SP), each of which includes the lower lens (500), the upper lens (700) and the barrier pattern (600),
wherein the barrier pattern (600) of each sub-pixel (SP) includes a different color material from the barrier pattern (600) of an adjacent sub-pixel (SP),
wherein, preferably:
the barrier pattern (600) of at least one sub-pixel (SP) of the plurality of sub-pixels (SP) includes a color material displaying a different color from the upper lens (700) of the at least one sub-pixel (SP) and the upper lens (700) of an adjacent sub-pixel (SP), and/or
the barrier pattern (600) of at least one sub-pixel (SP) of the plurality of sub-pixels (SP) includes a color material displaying a different color from the lower lens (500) of the at least one sub-pixel (SP) and the lower lens (500) of the adjacent sub-pixel (SP).
